# EUROPÄISCHE PATENTANMELDUNG

(11) **EP 2 871 776 A1**
(43) Veröffentlichungstag der Anmeldung: **13.05.2015**
(21) Anmeldenummer: 14186229.2
(22) Anmeldetag: 24.09.2014
(51) Int. Cl.: H03K 17/14, H03K 17/16, H03K 17/082

(54) **Leistungshalbleiterschaltung**

(30) Priorität: 07.11.2013 DE 102013112261
(71) Anmelder: SEMIKRON Elektronik GmbH & Co. KG, 90431 Nürnberg (DE)
(72) Erfinder: Bütow, Sven, 90431 Nürnberg (DE); Weiß, Rainer, 91052 Erlangen (DE)

(57) **Zusammenfassung**

Die Erfindung betrifft eine Leistungshalbleiterschaltung mit einen einen Steueranschluss und einen ersten und einen zweiten Lastromanschluss aufweisenden Leistungshalbleiterschalter und mit einer Ansteuerschaltung,
• wobei elektrisch zwischen der Ansteuerschaltung und dem Steueranschluss ein temperaturabhängiges Steueranschlusswiderstandselement geschalten ist, und/oder
• wobei elektrisch zwischen der Ansteuerschaltung und dem zweiten Lastromanschluss ein temperaturabhängiges Laststromanschlusswiderstandselement geschalten ist, und/oder
• wobei der Steueranschluss mit dem zweiten Lastromanschluss über einen ersten Stromzweig elektrisch verbunden ist, wobei elektrisch in den ersten Stromzweig ein temperaturabhängiges Steuerlaststromanschlusswiderstandelement geschaltet ist.

Die Erfindung reduziert bei Erwärmung eines Leistungshalbleiterschalters die Schaltverluste des Leistungshalbleiterschalters.

## Beschreibung

Die Erfindung betrifft eine Leistungshalbleiterschaltung.

Bei aus dem Stand der Technik bekannten Leistungshalbleitereinrichtungen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor) vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Infolge z.B. von parasitären Induktivitäten von Zuleitungen zu den Leistungshalbleiterschalter treten beim Ausschalten der Leistungshalbleiterschalter zwischen dem ersten und zweiten Laststromanschluss der Leistungshalbleiterschalter Spannungsspitzen auf, die falls diese zu hoch werden, zu einer Beschädigung oder Zerstörung der Leistungshalbleiterschalter führen können. Die Spannungsspitzen sind umso niedriger je langsamer das Ausschalten der Leistungshalbleiterschalter erfolgt. Je langsamer die Leistungshalbleiterschalter jedoch ausschaltetet werden, desto größer werden die energetischen Schaltverluste, die an den Leistungshalbleiterschaltern anfallen, was sich negativ auf den Wirkungsgrad der mittels der Leistungshalbleiterschalter realisierten elektrischen Schaltungen (z.B. Halbbrückenschaltungen) auswirkt. Aufgrund physikalischer Gegebenheiten schalten Leistungshalbleiterschalter bei zunehmender Erwärmung der Leistungshalbleiterschalter langsamer aus als im kalten Zustand, was zwar einerseits die beim Ausschalten der Leistungshalbleiterschalter auftretenden Spannungsspitzen absenkt aber andererseits die energetischen Verluste an den Leistungshalbleiterschaltern erhöht, so dass sich der Wirkungsgrad, der mittels der Leistungshalbleiterschalter realisierten elektrischen Schaltungen, verschlechtert.

Aus der DE 103 61 714 A1 ist ein zwischen dem Steueranschluss und dem zweiten Laststromanschluss eines Leistungshalbleiterschalters geschaltetes elektrisches Widerstandselement, das einen negativen Temperaturkoeffizienten aufweist, bekannt.

Es ist Aufgabe der Erfindung bei Erwärmung eines Leistungshalbleiterschalters die Schaltverluste des Leistungshalbleiterschalters zu reduzieren.

Diese Aufgabe wird gelöst durch eine Leistungshalbleiterschaltung mit einen einen Steueranschluss und einen ersten und einen zweiten Lastromanschluss aufweisenden Leistungshalbleiterschalter und mit einer mit dem Steueranschluss und mit dem zweiten Lastromanschluss elektrisch verbundenen Ansteuerschaltung, die zur Ansteuerung des Leistungshalbleiterschalters ausgebildet ist,
- wobei elektrisch zwischen der Ansteuerschaltung und dem Steueranschluss ein Steueranschlusswiderstandselement geschalten ist, wobei das Steueranschlusswiderstandselement thermisch an den Leistungshalbleiterschalter angekoppelt ist, wobei der ohmsche Widerstand des Steueranschlusswiderstandselements bei einer Temperatur des Steueranschlusswiderstandselements von 175°C oder 300°C maximal 90% des ohmschen Widerstands des Steueranschlusswiderstandselements bei einer Temperatur des Steueranschlusswiderstandselements von 20°C beträgt, und/oder
- wobei elektrisch zwischen der Ansteuerschaltung und dem zweiten Lastromanschluss ein Laststromanschlusswiderstandselement geschalten ist, wobei das Laststromanschlusswiderstandselement thermisch an den Leistungshalbleiterschalter angekoppelt ist, wobei der ohmsche Widerstand des Laststromanschlusswiderstandselements bei einer Temperatur des Laststromanschlusswiderstandselements von 175°C oder 300°C maximal 90% des ohmschen Widerstands des Laststromanschlusswiderstandselements bei einer Temperatur des Laststromanschlusswiderstandselements von 20°C beträgt, und/oder
- wobei der Steueranschluss mit dem zweiten Lastromanschluss über einen ersten Stromzweig elektrisch verbunden ist, wobei elektrisch in den ersten Stromzweig ein Steuerlaststromanschlusswiderstandelement geschaltet ist, wobei das Steuerlaststromanschlusswiderstandelement thermisch an den Leistungshalbleiterschalter angekoppelt ist, wobei der ohmsche Widerstand des Steuerlaststromanschlusswiderstandelements bei einer Temperatur des Steuerlaststromanschlusswiderstandelements von 175°C oder 300°C minimal 150% des ohmschen Widerstands des Steuerlaststromanschlusswiderstandelements bei einer Temperatur des Steuerlaststromanschlusswiderstandelements von 20°Cbeträgt.

Vorteilhafte Ausbildungen der Erfindung ergeben sich aus den abhängigen Ansprüchen.

Es erweist sich als vorteilhaft, dass falls die Leistungshalbleiterschaltung das Steueranschlusswiderstandselement aufweist, der ohmsche Widerstand des Steueranschlusswiderstandselements bei einer Temperatur des Steueranschlusswiderstandselements von 175°C oder 300°C vorzugsweise maximal 75% des ohmschen Widerstands des Steueranschlusswiderstandselements bei einer Temperatur des Steueranschlusswiderstandselements von 20°C beträgt.

Weiterhin erweist es sich als vorteilhaft, dass falls die Leistungshalbleiterschaltung das Steueranschlusswiderstandselement aufweist, der ohmsche Widerstand des Steueranschlusswiderstandselements bei einer Temperatur des Steueranschlusswiderstandselements von 175°C oder 300°C vorzugsweise maximal 60% des ohmschen Widerstands des Steueranschlusswiderstandselements bei einer Temperatur des Steueranschlusswiderstandselements von 20°C beträgt.

Weiterhin erweist es sich als vorteilhaft, dass falls die Leistungshalbleiterschaltung das Laststromanschlusswiderstandselement aufweist, der ohmsche Widerstand des Laststromanschlusswiderstandselements bei einer Temperatur des Laststromanschlusswiderstandselements von 175°C oder 300°C vorzugsweise maximal 75% des ohmschen Widerstands des Laststromanschlusswiderstandselements bei einer Temperatur des Laststromanschlusswiderstandselements von 20°C beträgt.

Weiterhin erweist es sich als vorteilhaft, dass falls die Leistungshalbleiterschaltung das Laststromanschlusswiderstandselement aufweist, der ohmsche Widerstand des Laststromanschlusswiderstandselements bei einer Temperatur des Laststromanschlusswiderstandselements von 175°C oder 300°C vorzugsweise maximal 60% des ohmschen Widerstands des Laststromanschlusswiderstandselements bei einer Temperatur des Laststromanschlusswiderstandselements von 20°C beträgt.

Ferner erweist es sich als vorteilhaft, dass falls die Leistungshalbleiterschaltung das Steuerlaststromanschlusswiderstandelement aufweist, der ohmsche Widerstand des Steuerlaststromanschlusswiderstandelements bei einer Temperatur des Steuerlaststromanschlusswiderstandelements von 175°C oder 300°C vorzugsweise minimal 200% des ohmschen Widerstands des Steuerlaststromanschlusswiderstandelements bei einer Temperatur des Steuerlaststromanschlusswiderstandelements von 20°Cbeträgt.

Weiterhin erweist es sich als vorteilhaft, dass falls die Leistungshalbleiterschaltung das Steuerlaststromanschlusswiderstandelement aufweist, der ohmsche Widerstand des Steuerlaststromanschlusswiderstandelements bei einer Temperatur des Steuerlaststromanschlusswiderstandelements von 175°C oder 300°C vorzugsweise minimal 500% des ohmschen Widerstands des Steuerlaststromanschlusswiderstandelements bei einer Temperatur des Steuerlaststromanschlusswiderstandelements von 20°Cbeträgt.

Ausführungsbeispiele der Erfindung sind in den Figuren dargestellt und werden im Folgenden näher erläutert. Dabei zeigen:
FIG 1 eine Leistungshalbleitereinrichtung,
FIG 2 eine erfindungsgemäße Leistungshalbleiterschaltung,
FIG 3 eine weitere Ausbildung einer erfindungsgemäßen Leistungshalbleiterschaltung,
FIG 4 eine weitere Ausbildung einer erfindungsgemäßen Leistungshalbleiterschaltung,
FIG 5 verschiedene Ausbildungen einer thermischen Ankopplung an einen Leistungshalbleiterschalter in Form einer schematisierten Schnittansicht und
FIG 6 eine weitere Ausbildung einer erfindungsgemäßen Leistungshalbleiterschaltung.

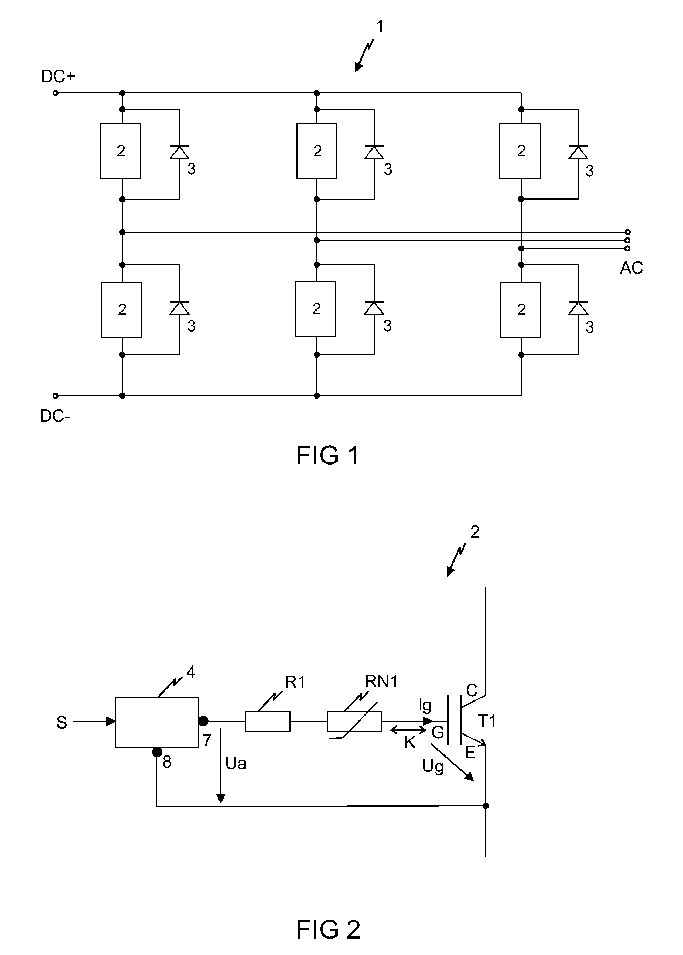

In FIG 1 ist eine Leistungshalbleitereinrichtung 1 dargestellt, die beispielhaft in Form einer sogenannten 3-phasigen Brückenschaltung ausgebildet ist. Die Leistungshalbleitereinrichtung 1 weist im Rahmen des Ausführungsbeispiels sechs erfindungsgemäße Leistungshalbleiterschaltungen 2 auf. In FIG 2 ist eine erfindungsgemäße Leistungshalbleiterschaltung 2 im Detail dargestellt. Den Leistungshalbleiterschaltungen 2 sind beim Ausführungsbeispiel jeweilig eine Freilaufdiode 3 elektrisch antiparallel geschaltet, wobei zu jeder Leistungshalbleiterschaltung 2 auch mehrere Freilaufdioden elektrisch antiparallel geschaltet sein können. Im Rahmen des dargestellten Ausführungsbeispiels erzeugt die Leistungshalbleitereinrichtung 1 aus einer linksseitig zwischen den Gleichspannungsanschlüssen DC+ und DC- eingespeisten Gleichspannung am Wechselspannungsanschluss AC eine 3-phasige Wechselspannung.

Die jeweilige Leistungshalbleiterschaltung 2 weist einen Leistungshalbleiterschalter T1 auf, der einen ersten Laststromanschluss C, einen zweiten Laststromanschluss E und einen Steueranschluss G aufweist. Im Rahmen des Ausführungsbeispiels liegt der erste Laststromanschluss C in Form des Kollektors des Leistungshalbleiterschalters T1 und der zweite Laststromanschluss E in Form des Emitters des Leistungshalbleiterschalters T1 und der Steueranschluss G in Form des Gate des Leistungshalbleiterschalters T1 vor. Der Leistungshalbleiterschalter liegt vorzugsweise in Form eines Transistors, wie z.B. eines IGBT (Insulated Gate Bipolar Transistor) oder eines MOSFET (Metal Oxide Semiconductor Field Effect Transistor) vor, wobei im Rahmen des Ausführungsbeispiels der Leistungshalbleiterschalter T1 in Form eines n-kanal IGBT vorliegt.

Weiterhin weist die Leistungshalbleiterschaltung 2 eine Ansteuerschaltung 4 auf, die zur Ansteuerung des Leistungshalbleiterschalters T1 ausgebildet ist, wobei die Ansteuerschaltung 4 mit dem Steueranschluss G des Leistungshalbleiterschalter T1 und mit dem zweiten Laststromanschluss E des Leistungshalbleiterschalter T1, elektrisch verbunden ist. Die Ansteuerschaltung 4 kann einen einzelnen oder mehrere integrierte Schaltkreise, und/oder mehrere diskrete elektrische Bauelemente aufweisen.

Die Ansteuerschaltung 4 erzeugt ein Ansteuersignal zur Ansteuerung des Leistungshalbleiterschalter T1, indem sie an ihrem Anschluss 7 bezogen auf Ihren Anschluss 8 eine positive oder negative Ausgangspannung Ua erzeugt. Wenn der Leistungshalbleiterschalter T1 eingeschaltet werden sollen, wird von der Ansteuerschaltung 4 eine positive Ausgangsspannung Ua erzeugt. Wenn der Leistungshalbleiterschalter T1 ausgeschaltet werden soll, wird von der Ansteuerschaltung 4 eine negative Ausgangsspannung Ua erzeugt. Im Rahmen des Ausführungsbeispiels erzeugt die Ansteuerschaltung 4 das Ansteuersignal dabei in Abhängigkeit eines von einer externen Steuereinrichtung (nicht dargestellt) erzeugten Steuersignals S.

Zwischen der Ansteuerschaltung 4 und dem Steueranschluss G ist ein Steueranschlusswiderstandselement RN1 elektrisch geschalten. Das Steueranschlusswiderstandselement RN1 ist thermisch an den Leistungshalbleiterschalter T1 angekoppelt, so dass wenn der Leistungshalbleiterschalter T1 sich erwärmt, das Steueranschlusswiderstandselement RN1 erwärmt wird. Das Steueranschlusswiderstandselement RN1 ist thermisch leitend mit dem Leistungshalbleiterschalter T1 verbunden. In FIG 2 ist die thermische Ankopplung des Steueranschlusswiderstandselements RN1 an den Leistungshalbleiterschalter T1 durch einen Doppelpfeil K dargestellt. Das Steueranschlusswiderstandselement RN1 ist als ein NTC-Widerstand (Negative Temperature Coefficient) ausgebildet, d.h. der ohmsche Widerstand des Steueranschlusswiderstandselements nimmt zumindest in einem bestimmten Temperaturbereich mit zunehmender Temperatur ab. Das Steueranschlusswiderstandselement RN1 weist zumindest in einem bestimmten Temperaturbereich einen negativen Temperaturkoeffizienten auf. Der ohmsche Widerstand des Steueranschlusswiderstandselements RN1 beträgt erfindungsgemäß bei einer Temperatur des Steueranschlusswiderstandselements RN1 von 175°C oder 300°C maximal 90%, vorzugsweise maximal 75%, vorzugsweise maximal 60% des ohmschen Widerstands des Steueranschlusswiderstandselements RN1 bei einer Temperatur des Steueranschlusswiderstandselements RN1 von 20°C. In dem Temperaturbereich von 20°C bis 175°C oder bis 300°C sinkt der ohmsche Widerstand vorzugsweise mit steigender Temperatur monoton, insbesondere streng monoton.

Beim Ausführungsbeispiel weist das Steueranschlusswiderstandselement RN1 bei 20°C einen ohmschen Widerstand von 10Ω auf und bei 175°C oder 300°C von maximal 9 Ω auf.

Aufgrund physikalischer Gegebenheiten schaltet ein Leistungshalbleiterschalter bei zunehmender Erwärmung des Leistungshalbleiterschalter langsamer aus als im kalten Zustand (z.B. bei 20°C). Die Geschwindigkeit mit der der Leistungshalbleiterschalter T1 ausschaltet hängt aber auch von der Geschwindigkeit ab mit der die zwischen dem Steueranschluss G und dem zweiten Lastromanschluss E anliegende und auf den zweiten Lastromanschluss E bezogen Steueranschlussspannung Ug zum Ausschalten des Leistungshalbleiterschalters T1 sinkt. Je schneller die Steueranschlussspannung Ug absinkt umso schneller schaltet der Leistungshalbleiterschalter T1 aus, d.h. umso höher ist die Ausschaltgeschwindigkeit mit der der Leistungshalbleiterschalter T1 ausschaltet und den zwischen dem ersten und zweiten Lastromanschluss C und E fließenden Laststrom unterbricht. Bei zunehmender Erwärmung des Leistungshalbleiterschalters steigt infolge der thermischen Ankopplung des Steueranschlusswiderstandselements RN1 an den Leistungshalbleiterschalter T1 die Temperatur des Steueranschlusswiderstandselements RN1 an, was eine Verminderung des ohmschen Widerstand des Steueranschlusswiderstandselements RN1 zur Folge hat. Die Verminderung des ohmschen Widerstand des Steueranschlusswiderstandselements RN1 bewirkt ein Erhöhung des Steuerstroms Ig in negativer Richtung, wenn zum Ausschalten des LeistungshalbleiterschaltersT1 von der Ansteuerschaltung 4 anstelle der positiven Ausgangsspannung Ua eine negative Ausgangsspannung Ua erzeugt wird. Infolge davon sinkt die Steueranschlussspannung Ug schneller ab als bei unverminderten ohmschen Widerstand des Steueranschlusswiderstandselements RN1, was eine Erhöhung der Ausschaltgeschwindigkeit mit der der Leistungshalbleiterschalter T1 ausgeschaltet wird bewirkt. Die Erhöhung der Ausschaltgeschwindigkeit mit der der Leistungshalbleiterschalter T1, infolge der Verminderung des ohmschen Widerstands des Steueranschlusswiderstandselements RN1, ausgeschaltet wird, wirkt der Verminderung der Ausschaltgeschwindigkeit aufgrund der Erwärmung des Leistungshalbleiterschalters T1 entgegen. Eine auftretende Erhöhung der Schaltverluste des Leistungshalbleiterschalters T1 aufgrund einer Temperaturerhöhung des Leistungshalbleiterschalters T1 wird hierdurch mindestens reduziert oder sogar vermieden.

Zwischen der Ansteuerschaltung 4 und dem Leistungshalbleiterschalter T1 ist vorzugsweise ein zusätzliches ohmsches Widerstandselement R1 geschalten. Das ohmsche Widerstandselement R1 kann z.B. in Form eines techniküblichen Kohleschicht- oder Metallfilmwiderstands ausgebildet sein. Der elektrische Widerstand des ohmschen Widerstandselements R1 weist vorzugsweise eine nur relativ geringe Temperabhängigkeit auf, die vorzugsweise im techniküblichen von Kohleschicht- oder Metallfilmwiderständen liegt. Das ohmsche Widerstandselement R1 kann elektrisch in Reihe zum Steueranschlusswiderstandselements RN1, zwischen der Ansteuerschaltung 4 und dem Steueranschluss G des Leistungshalbleiterschalter T1 oder zwischen der Ansteuerschaltung 4 und dem zweiten Laststromanschluss E des Leistungshalbleiterschalters T1 geschalten sein. Das ohmsche Widerstandselement R1 stellt sicher, dass unabhängig von der Temperatur des Leistungshalbleiterschalters T1 ein bestimmter ohmscher Mindestwiderstand zwischen Ansteuerschaltung 4 und dem Leistungshalbleiterschalter T1 elektrisch geschaltet ist. Beim Ausführungsbeispiel beträgt der elektrische Widerstand des ohmschen Widerstandselements R1 1 Ω.

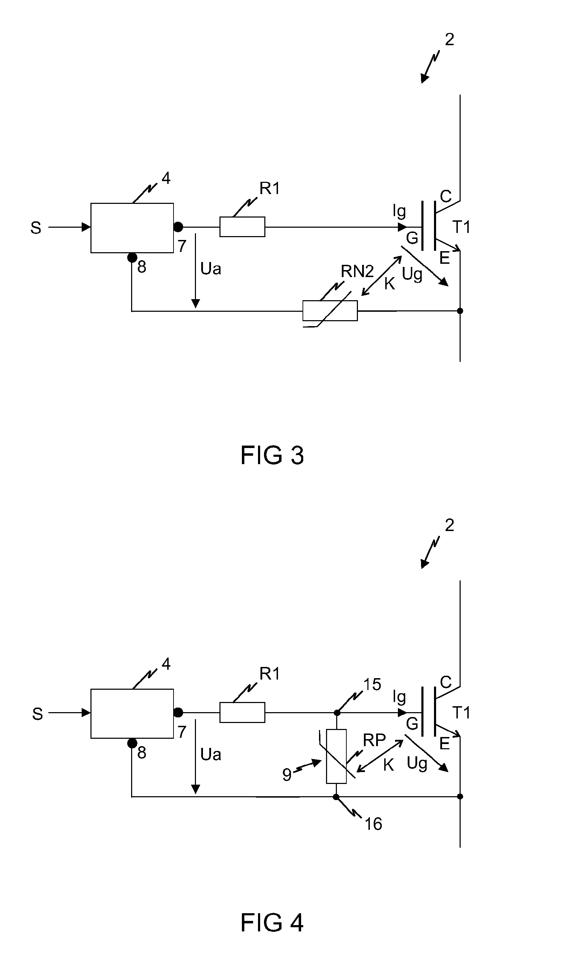

In FIG 3 ist eine weitere Ausbildung einer erfindungsgemäßen Leistungshalbleiterschaltung 2 im Detail dargestellt. Die Leistungshalbleiterschaltung 2 gemäß FIG 3 entspricht dabei der Leistungshalbleiterschaltung 2 gemäß FIG 2 bis auf das Merkmal, dass anstatt des Steueranschlusswiderstandselements RN1, die Leistungshalbleiterschaltung 2 gemäß FIG 3 ein Laststromanschlusswiderstandselement RN2 aufweist, das elektrisch zwischen der Ansteuerschaltung 4 und dem zweiten Lastromanschluss E des Leistungshalbleiterschalter T1 geschalten ist. Das Laststromanschlusswiderstandselement RN2 ist dabei identisch wie das Steueranschlusswiderstandselements RN1 ausgebildet, so dass bezüglich der Beschreibung des Laststromanschlusswiderstandselements RN2 auf die oben stehende Beschreibung des Steueranschlusswiderstandselements RN1 verwiesen wird. Das Laststromanschlusswiderstandselement RN2 ist thermisch an den Leistungshalbleiterschalter T1 angekoppelt, was durch einen Doppelpfeil K dargestellt ist. Beim Ausführungsbeispiel weist das Laststromanschlusswiderstandselement RN2 bei 20°C einen ohmsche Widerstand von 10Ω auf und bei 175°C oder 300°C von maximal 9 Ω auf. Das Funktionsprinzip der Schaltung gemäß FIG 3 entspricht dem beim Ausführungsbeispiel gemäß FIG 2 beschriebenen Funktionsprinzip.

Zwischen der Ansteuerschaltung 4 und dem Leistungshalbleiterschalter T1 ist vorzugsweise ein zusätzliches ohmsches Widerstandselement R1 geschalten. Das ohmsche Widerstandselement R1 kann z.B. in Form eines techniküblichen Kohleschicht- oder Metallfilmwiderstands ausgebildet sein. Das elektrische Widerstand des ohmschen Widerstandselements R1 weist vorzugsweise eine nur relativ geringe Temperabhängigkeit auf, die vorzugsweise im techniküblichen von Kohleschicht- oder Metallfilmwiderständen liegt. Das ohmsche Widerstandselement R1 kann zwischen der Ansteuerschaltung 4 und dem Steueranschluss G des Leistungshalbleiterschalters T1 oder elektrisch in Reihe zum Laststromanschlusswiderstandselement RN2 zwischen der Ansteuerschaltung 4 und dem zweiten Laststromanschluss des Leistungshalbleiterschalters T1 geschalten sein. Das ohmsche Widerstandselement R1 stellt sicher, dass unabhängig von der Temperatur des Leistungshalbleiterschalters T1 ein bestimmter ohmscher Mindestwiderstand zwischen Ansteuerschaltung 4 und dem Leistungshalbleiterschalter T1 elektrisch geschaltet ist. Beim Ausführungsbeispiel beträgt der elektrische Widerstand des ohmschen Widerstandselements R1 1 Ω.

Das Steueranschlusswiderstandselement RN1 und das Laststromanschlusswiderstandselement RN2 bestehen techniküblich aus speziell dotierten Halbleitermaterialien wie z.B. Silizium, oder aus Metalloxiden von z.B. Mangan, Nickel, Eisen, Kobalt, Titan oder Kupfer.

In FIG 4 ist eine weitere Ausbildung einer erfindungsgemäßen Leistungshalbleiterschaltung 2 im Detail dargestellt. Die Leistungshalbleiterschaltung 2 gemäß FIG 4 entspricht dabei der Leistungshalbleiterschaltung 2 gemäß FIG 2 bis auf die Merkmale, dass bei der Leistungshalbleiterschaltung 2 gemäß FIG 4 der Steueranschluss G mit dem zweiten Lastromanschluss E über einen ersten Stromzweig 9 elektrisch verbunden ist, wobei elektrisch in den ersten Stromzweig 9 ein Steuerlaststromanschlusswiderstandelement RP geschaltet ist, wobei das Steuerlaststromanschlusswiderstandelement RP thermisch an den Leistungshalbleiterschalter T1 angekoppelt ist, wobei der ohmsche Widerstand des Steuerlaststromanschlusswiderstandelements RP bei einer Temperatur des Steuerlaststromanschlusswiderstandelements RP von 175°C oder 300°C minimal 150%, vorzugsweise minimal 200°, vorzugsweise minimal 500% des ohmschen Widerstands des Steuerlaststromanschlusswiderstandelements RP bei einer Temperatur des Steuerlaststromanschlusswiderstandelements RP von 20°C beträgt. Der Stromzweig 9 ist im Rahmen des Ausführungsbeispiels elektrisch parallel zum Steueranschluss G und zweiten Lastromanschluss E des Leistungshalbleiterschalters T1 geschalten. Beim Ausführungsbeispiel ist der erste Anschluss 15 des Steuerlaststromanschlusswiderstandelements RP elektrisch leitend mit dem Steueranschluss G und der zweite Anschluss 16 des Steuerlaststromanschlusswiderstandelements RP elektrisch leitend mit dem zweiten Lastromanschluss E des Leistungshalbleiterschalter T1 verbunden.

Das Steuerlaststromanschlusswiderstandelement RP ist thermisch an den Leistungshalbleiterschalter T1 angekoppelt, so dass wenn der Leistungshalbleiterschalter T1 sich erwärmt, das Steuerlaststromanschlusswiderstandelement RP erwärmt wird. Das Steuerlaststromanschlusswiderstandelement RP ist thermisch leitend mit dem Leistungshalbleiterschalter T1 verbunden. In FIG 4 ist die thermische Ankopplung des Steuerlaststromanschlusswiderstandelements RP an den Leistungshalbleiterschalter T1 durch einen Doppelpfeil K dargestellt. Das Steuerlaststromanschlusswiderstandelement RP ist als ein PTC-Widerstand (Positive Temperature Coefficient) ausgebildet, d.h. der ohmsche Widerstand des Steuerlaststromanschlusswiderstandelement RP erhöht sich zumindest in einem bestimmten Temperaturbereich mit zunehmender Temperatur. Das Steuerlaststromanschlusswiderstandelement RP weist zumindest in einem bestimmten Temperaturbereich einen positiven Temperaturkoeffizienten auf. In dem Temperaturbereich von 20°C bis 175°C oder bis 300°C erhöht sich der ohmsche Widerstand vorzugsweise mit steigender Temperatur monoton, insbesondere streng monoton.

Beim Ausführungsbeispiel weist das Steuerlaststromanschlusswiderstandelement RP bei 20°C einen ohmschen Widerstand von 100Ω auf und bei 175°C oder 300°C von minimal 150 Ω auf.

Bei zunehmender Erwärmung des Leistungshalbleiterschalters T1 steigt infolge der thermischen Ankopplung des Steuerlaststromanschlusswiderstandelements RP an den Leistungshalbleiterschalter T1 die Temperatur des Steuerlaststromanschlusswiderstandelements RP an, was eine Erhöhung des ohmschen Widerstands des Steuerlaststromanschlusswiderstandelements RP zur Folge hat. Die Erhöhung des ohmschen Widerstand des Steuerlaststromanschlusswiderstandelement RP bewirkt eine Erhöhung des Steuerstroms Ig in negative Richtung, wenn zum Ausschalten des Leistungshalbleiterschalters T1 von der Ansteuerschaltung 4 anstelle der positiven Ausgangsspannung Ua eine negative Ausgangsspannung Ua erzeugt wird. Infolge davon sinkt die Steueranschlussspannung Ug schneller ab als bei unerhöhtem ohmschen Widerstand des Steuerlaststromanschlusswiderstandelements RP, was eine Erhöhung der Ausschaltgeschwindigkeit mit der der Leistungshalbleiterschalter T1 ausgeschaltet wird bewirkt.

Vorzugsweise ist elektrisch zwischen der Ansteuerschaltung 4 und dem Steuerlaststromanschlusswiderstandelement RP ein ohmsches Widerstandselement R1 geschalten. Das ohmsche Widerstandselement R1 kann z.B. in Form eines techniküblichen Kohleschicht- oder Metallfilmwiderstands ausgebildet sein. Der elektrische Widerstand des ohmschen Widerstandselements R1 weist vorzugsweise eine geringe Temperabhängigkeit auf, die vorzugsweise im techniküblichen von Kohleschicht- oder Metallfilmwiderständen liegt. Das ohmsche Widerstandselement R1 kann elektrisch zwischen der Ansteuerschaltung 4 und dem ersten Anschluss 15 des Steuerlaststromanschlusswiderstandelements RP oder zwischen der Ansteuerschaltung 4 und dem zweiten Anschluss 16 des Steuerlaststromanschlusswiderstandelements RP geschalten sein. Falls die Ansteuerschaltung 4 intern einen endsprechend großen ohmschen Innenwiderstand aufweist, der einen Abfall der negativen Ausgangsspannung Ua bewirkt, wenn bei einer Temperatur von 20°C der ohmsche Widerstand des Steuerlaststromanschlusswiderstandelements RP gering ist und somit die Ansteuerschaltung 4 mit dem durch das Steuerlaststromanschlusswiderstandelement RP fließenden Stroms stärker belastet wird als bei einer höheren Temperatur des Steuerlaststromanschlusswiderstandelements RP, dann kann das ohmsche Widerstandselement R1 auch entfallen.

Beim Ausführungsbeispiel beträgt der elektrische Widerstand des ohmschen Widerstandselements R1 10Ω.

Das Steuerlaststromanschlusswiderstandelements RP besteht techniküblich z.B. aus speziell dotiertem Silizium oder Bariumtitanat.

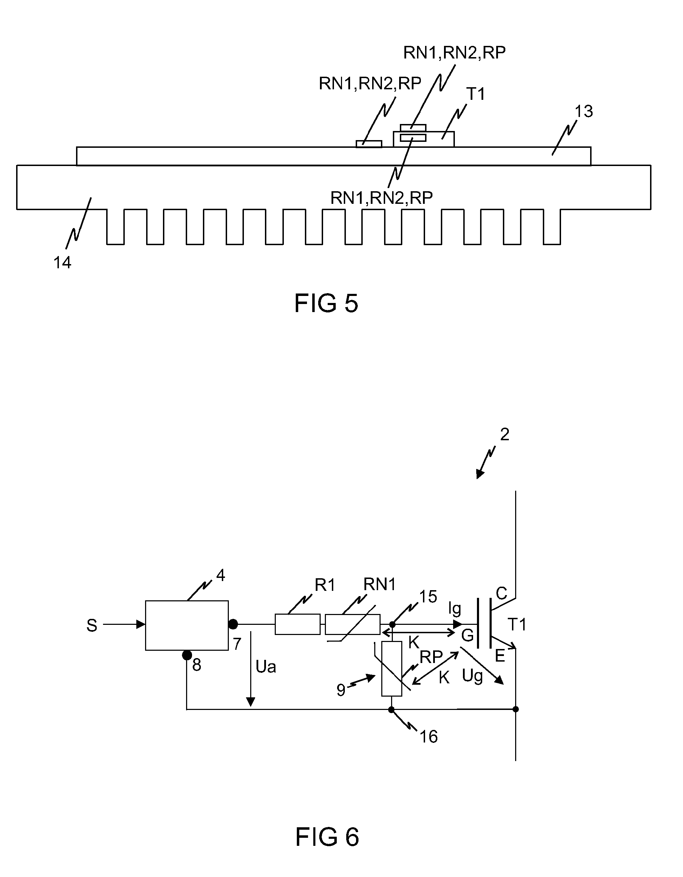

In FIG 5 sind beispielhaft verschiedene Ausbildungen einer thermischen Ankopplung des Steueranschlusswiderstandselements RN1, des Laststromanschlusswiderstandselements RN2 bzw. des Steuerlaststromanschlusswiderstandelements RP an den Leistungshalbleiterschalter T1 in Form einer schematisierten Schnittansicht dargestellt. Der Leistungshalbleiterschalter T1 ist auf einem Substrat 13 angeordnet. Das Substrat 13 ist vorzugsweise auf einem Kühlkörper 14 angeordnet. Das Substrat 13 ist vorzugsweise als Direct Copper Bonded Substrat (DCB-Substrat) oder als Insulated Metal Substrat (IMS) ausgebildet. Das Steueranschlusswiderstandselement RN1, das Laststromanschlusswiderstandselement RN2 bzw. das Steuerlaststromanschlusswiderstandelements RP kann z.B. thermisch an den Leistungshalbleiterschalter T1 angekoppelt sein, indem das Steueranschlusswiderstandselement RN1, das Laststromanschlusswiderstandselement RN2 bzw. das Steuerlaststromanschlusswiderstandelements RP auf dem Substrat 13 oder auf dem Leistungshalbleiterschalter T1 angeordnet oder monolithisch in den Leistungshalbleiterschalter T1 integriert ist.

Es sei an dieser Stelle angemerkt, dass die in den Figuren 2 bis 4 angegeben Ausbildungen der Erfindung bzw. einzelne Merkmale der Ausbildungen der Erfindung bzw. einzelne Merkmale von vorteilhaften Ausbildungen der Erfindung beliebig miteinander kombiniert werden können. So kann z.B. die Leistungshalbleiterschaltung 2 sowohl das Steueranschlusswiderstandselement RN1 als auch das Laststromanschlusswiderstandselement RN2 aufweisen, oder sowohl das Steuerlaststromanschlusswiderstandelements RP als auch das Steueranschlusswiderstandselement RN1 und/oder das Laststromanschlusswiderstandselement RN2 aufweisen. In FIG 6 ist z.B. eine Ausbildung der Erfindung angegeben in der die Ausbildungen der Erfindungen gemäß FIG 2 und FIG 4 miteinander kombiniert sind.

Es sei an dieser Stelle angemerkt, dass die Leistungshalbleiterschaltung 2 noch weitere Leistungshalbleiterschalter aufweisen kann, welche im Allgemeinen elektrisch parallel oder in Reihe mit dem Leistungshalbleiterschalter T1 geschalten sind, wobei die Steueranschlüsse und zweiten Laststromanschlüsse der weiteren Leistungshalbleiterschalter mit der Ansteuerschaltung in analoger Weise wie oben beschrieben elektrisch verbunden sind und die weitere Leistungshalbleiterschalter von der Ansteuerschaltung analog wie oben beschrieben angesteuert werden.

Weiterhin sei angemerkt, dass die bezüglich des Ausschaltens des Leistungshalbleiterschalters beschriebene Funktionsweise der Erfindung im Hinblick auf die Schaltverluste in analoger Weise auch für das Einschalten des Leistungshalbleiterschalters gilt, so dass durch die Erfindung auch eine beim Einschalten des Leistungshalbleiterschalters, aufgrund einer Temperaturerhöhung des Leistungshalbleiterschalters T1, auftretende Erhöhung der Schaltverluste des Leistungshalbleiterschalters T1 mindestens reduziert oder sogar vermieden wird.

Es sei auch angemerkt, das techniküblich oftmals für das Einschalten und für das Ausschalten des Leistungshalbleiterschalters die Ansteuerschaltung über einen für das Einschalten und das Ausschalten jeweilig zuständigen Stromzweig mit dem Leistungshalbleiterschalter verbunden sein kann, wobei im jeweiligen Stromzweig unterschiedliche ohmsche Gatevorwiderstände geschaltet sind. Entsprechend kann auch ein Steueranschlusswiderstandselement, Laststromanschlusswiderstandselement und/oder ein Steuerlaststromanschlusswiderstandelement bzw. ein ohmsches Widerstandelement für das Ausschalten des Leistungshalbleiterschalters und ein weiteres Steueranschlusswiderstandselement, weiteres Laststromanschlusswiderstandselement und/oder ein weiteres Steuerlaststromanschlusswiderstandelement bzw. ein weiteres ohmsches Widerstandelement für das Einschalten des Leistungshalbleiterschalters vorhanden sein.

## Patentansprüche

1. Leistungshalbleiterschaltung mit einen einen Steueranschluss (G) und einen ersten und einen zweiten Lastromanschluss (C,E) aufweisenden Leistungshalbleiterschalter (T1) und mit einer mit dem Steueranschluss (G) und mit dem zweiten Lastromanschluss (E) elektrisch verbundenen Ansteuerschaltung (4), die zur Ansteuerung des Leistungshalbleiterschalters (T1) ausgebildet ist,
• wobei elektrisch zwischen der Ansteuerschaltung (4) und dem Steueranschluss (G) ein Steueranschlusswiderstandselement (RN1) geschalten ist, wobei das Steueranschlusswiderstandselement (RN1) thermisch an den Leistungshalbleiterschalter (T1) angekoppelt ist, wobei der ohmsche Widerstand des Steueranschlusswiderstandselements (T1) bei einer Temperatur des Steueranschlusswiderstandselements (T1) von 175°C oder 300°C maximal 90% des ohmschen Widerstands des Steueranschlusswiderstandselements (T1) bei einer Temperatur des Steueranschlusswiderstandselements (T1) von 20°C beträgt, und/oder
• wobei elektrisch zwischen der Ansteuerschaltung (4) und dem zweiten Lastromanschluss (E) ein Laststromanschlusswiderstandselement (RN2) geschalten ist, wobei das Laststromanschlusswiderstandselement (RN2) thermisch an den Leistungshalbleiterschalter (T1) angekoppelt ist, wobei der ohmsche Widerstand des Laststromanschlusswiderstandselements (RN2) bei einer Temperatur des Laststromanschlusswiderstandselements (RN2) von 175°C oder 300°C maximal 90% des ohmschen Widestands des Laststromanschlusswiderstandselements (RN2) bei einer Temperatur des Laststromanschlusswiderstandselements (RN2) von 20°C beträgt, und/oder
• wobei der Steueranschluss (G) mit dem zweiten Lastromanschluss (E) über einen ersten Stromzweig (9) elektrisch verbunden ist, wobei elektrisch in den ersten Stromzweig (9) ein Steuerlaststromanschlusswiderstandelement (RP) geschaltet ist, wobei das Steuerlaststromanschlusswiderstandelement (RP) thermisch an den Leistungshalbleiterschalter (T1) angekoppelt ist, wobei der ohmsche Widerstand des Steuerlaststromanschlusswiderstandelements (RP) bei einer Temperatur des Steuerlaststromanschlusswiderstandelements (RP) von 175°C oder 300°C minimal 150% des ohmschen Widerstands des Steuerlaststromanschlusswiderstandelements (RP) bei einer Temperatur des Steuerlaststromanschlusswiderstandelements (RP) von 20°C beträgt.

2. Leistungshalbleiterschaltung nach Anspruch 1, **dadurch gekennzeichnet, dass** falls die Leistungshalbleiterschaltung (2) das Steueranschlusswiderstandselement (RN1) aufweist, der ohmsche Widerstand des Steueranschlusswiderstandselements (RN1) bei einer Temperatur des Steueranschlusswiderstandselements (RN1) von 175°Coder 300°C maximal 75% des ohmschen Widerstands des Steueranschlusswiderstandselements (RN1) bei einer Temperatur des Steueranschlusswiderstandselements (RN1) von 20°C beträgt.

3. Leistungshalbleiterschaltung nach Anspruch 1, **dadurch gekennzeichnet, dass** falls die Leistungshalbleiterschaltung (2) das Steueranschlusswiderstandselement (RN1) aufweist, der ohmsche Widerstand des Steueranschlusswiderstandselements (RN1) bei einer Temperatur des Steueranschlusswiderstandselements (RN1) von 175°Coder 300°C maximal 60% des ohmschen Widerstands des Steueranschlusswiderstandselements (RN1) bei einer Temperatur des Steueranschlusswiderstandselements (RN1) von 20°C beträgt.

4. Leistungshalbleiterschaltung nach einem der vorhergehenden Ansprüche, **dadurch gekennzeichnet, dass** falls die Leistungshalbleiterschaltung (2) das Laststromanschlusswiderstandselement (RN2) aufweist, der ohmsche Widerstand des Laststromanschlusswiderstandselements (RN2) bei einer Temperatur des Laststromanschlusswiderstandselements (RN2) von 175°C oder 300°C maximal 75% des ohmschen Widerstands des Laststromanschlusswiderstandselements (RN2) bei einer Temperatur des Laststromanschlusswiderstandselements (RN2) von 20°C beträgt.

5. Leistungshalbleiterschaltung nach einem der Ansprüche 1 bis 3, **dadurch gekennzeichnet, dass** falls die Leistungshalbleiterschaltung (2) das Laststromanschlusswiderstandselement (RN2) aufweist, der ohmsche Widerstand des Laststromanschlusswiderstandselements (RN2) bei einer Temperatur des Laststromanschlusswiderstandselements (RN2) von 175°C oder 300°C maximal 60% des ohmschen Widerstands des Laststromanschlusswiderstandselements (RN2) bei einer Temperatur des Laststromanschlusswiderstandselements (RN2) von 20 °C beträgt.

6. Leistungshalbleiterschaltung nach einem der vorhergehenden Ansprüche, **dadurch gekennzeichnet, dass** falls die Leistungshalbleiterschaltung (2) das Steuerlaststromanschlusswiderstandelement (RP) aufweist, der ohmsche Widerstand des Steuerlaststromanschlusswiderstandelements (RP) bei einer Temperatur des Steuerlaststromanschlusswiderstandelements (RP) von 175°C oder 300°C minimal 200% des ohmschen Widerstands des Steuerlaststromanschlusswiderstandelements (RP) bei einer Temperatur des Steuerlaststromanschlusswiderstandelements (RP) von 20°C beträgt.

7. Leistungshalbleiterschaltung nach einem der Ansprüche 1 bis 5, **dadurch gekennzeichnet, dass** falls die Leistungshalbleiterschaltung (2) das Steuerlaststromanschlusswiderstandelement (RP) aufweist, der ohmsche Widerstand des Steuerlaststromanschlusswiderstandelements bei einer Temperatur des Steuerlaststromanschlusswiderstandelements (RP) von 175°C oder 300°C minimal 500% des ohmschen Widerstands des Steuerlaststromanschlusswiderstandelements (RP) bei einer Temperatur des Steuerlaststromanschlusswiderstandelements (RP) von 20°C beträgt.
